Europäisches Patentamt

European Patent Office

Office européen des brevets

(19)

(11) Publication number: 0 279 909
A2

# (12) EUROPEAN PATENT APPLICATION

(21) Application number: 87115580.0

(22) Date of filing: 23.10.87

(51) Int. Cl.4: H03M 7/40 , H04L 25/32

(30) Priority: 04.11.86 IT 2222386

(43) Date of publication of application:
31.08.88 Bulletin 88/35

(84) Designated Contracting States:
BE DE ES FR GB GR NL SE

(71) Applicant: TELETTRA Telefonia Elettronica e
Radio S.p.A.
Via Cornaglia 19
I-20124 Milano(IT)

(72) Inventor: Cucchi, Silvio
Via S.Invenzio 9
I-20080 Gaggiano(IT)
Inventor: Corradi, Vittorio
Via S.Gottardo 58
I-20052 Monza(IT)
Inventor: Capriata, Stefano
Via Teocrito 36
I-20128 Milano(IT)

(74) Representative: Incollingo, Italo
Telettra S.p.A Patent Department Via Trento
no. 30
I-20059 Vimercate (Milano)(IT)

(54) Variable lenght code and devices for high frequency transmission.

(57) The invention concerns a code with variable length of a type prefix/suffix ( [px..] sx), suitable for the parallel treatment of the words of said code, in particular for the compactation of said words into constant length packets at the transmission end and to the successive extraction at the receive end.

The code permits to separate at the receive end, the two operations of EXTRACTION and DECODING; essentially this may result in high speed applications wherein these operations cannot be performed within the clock cycle.

Besides said code permits the EXTRACTION operation to be simplified by considerably reducing the dimensions of the necessary hardware.

Its efficiency with particular distributions of messages is particularly high (97-98%).

Finally a detailed analysis is given of an application with a particular step code [px..] sx.

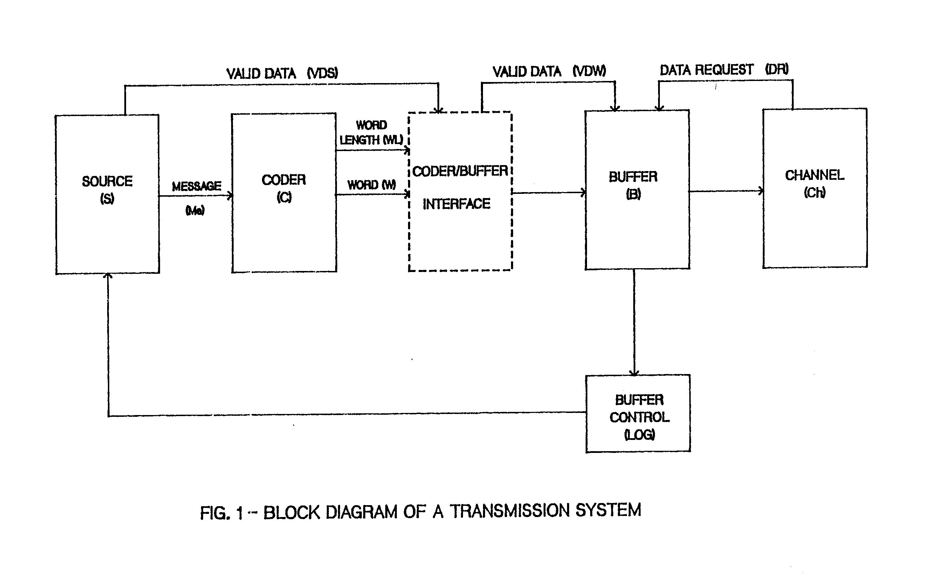

FIG. 1 – BLOCK DIAGRAM OF A TRANSMISSION SYSTEM

EP 0 279 909 A2

The present invention refers generally to the parallel treatment of words of variable length and frequency in the high frequency digital transmission systems, more particularly to compact, at the transmit end, said words into constant length packets and to successively extract them at the receive end.

To obtain the information on the word length it was necessary up to now to analyze the n bits of the same word.

This complex analysis has the consequence that for words with codes of considerable length the implementing hardware is very extended with corresponding high limits in the working frequencies; furthermore, the analytical complexity resulted necessarily in big machines which however had to work at frequencies reduced according to their complex structure.

The object of the present invention is a system to extract the information of the word length (WL) by looking at a number of reduced bits of a certain section, said few bits containing nevertheless the desired information on the word length.

These reduced bits are now realizable in a very simple way, e.g with the aid of a combining network on the initial word with the special prefix/suffix step code according to the present invention.

Thanks to the reduction of the number of single words to be observed, the implementing hardware is reduced in a more than proportional, e.g quadratic measure and consequently at a parity of technology, a maximum increase in the operating speed is obtained.

The system according to the invention is now essentially characterized by the fact that it operates with a step code type px.. sx, in which each word W (with the exception of the words of maximum length N) is formed by a sequence of a number variable form O to N/st of prefixes px followed by only one suffix sx.

Some of the other features of the invention can be read from subclaims 2 and 3.

The device to implement this system is now characterized in that at the transmission end a word compacter WC is inserted between a coder C and a buffer B; which compacter on reception from coder C of words W of variable length WL transmits to buffer B packets of bits of fixed length M by operating at a peak frequency equal to $N/M \cdot Fs$.

In order to focus the problem and in view of the fact that the receive system is specular with respect to the transmit system, reference is made to the block diagram of figure 1.

Examining the block diagram from the left to the right:

1) Source S transmits with a certain probability messages Me belonging to a typical set of said source S. Source S can transmit messages Me with either a constant or a variable frequency, anyway with a peak frequency equalling Fs (SOURCE frequency).

2) Coder C translates messages Me into words W belonging to a code which may have either a constant or a variable length. It is often convenient to make use of a variable length code. In fact, adapting the code to the statistic of source S, a considerable bit rate is saved, i.e a saving of transmitted bits is obtained at a parity of transmitted information. Being coder C nothing else but a transcoding table, it is a slave with respect to source S, i.e the peak frequency (Fc) of words equals Fs (SOURCE frequency).

3) In order to interface the transmission of variable speed information, which generally is due to the variable transmission of source S as well as to the variable length of words W of said code, with a Ch (CHANNEL: which acquires constant speed inforamtion Fch CHANNEL) use must be made of a buffer B (elastic memory).

Through feedback, the stuffing level of buffer B controls the operation of source S altering its characteristics.

When buffer B becomes too much stuffed up, the feedback forces source S to decrease the bit rate of messages Me, hence the signal quality.

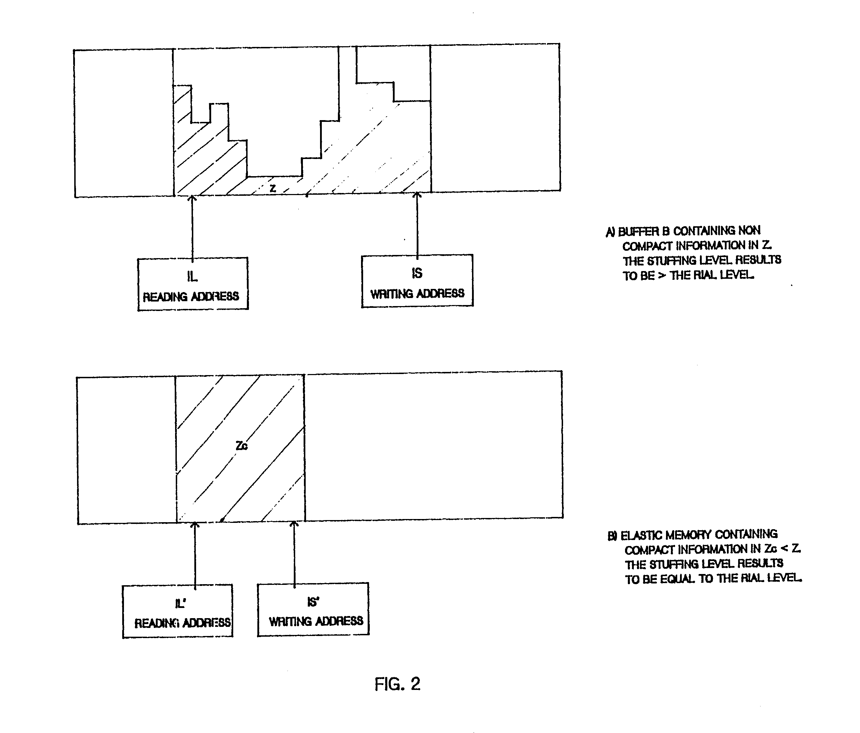

Therefore, in order to maximize the signal quality the stuffing level measured by control logic LOG must be the rms value. All memory pads between reading address IL and writing address SL must contain useful information (figure 2).

4) To the effect, interface CODER/BUFFER must be inserted which changes the information format. Two choices are possible:

a) Parallel to serial conversion (P/S) of the words supplied by the coder (C) (SERIAL mode).

b) Compacting into constant length packets by means of word compacter WC of the words produced by coder C and parallel storage in buffer B (PARALLEL MODE). Actually this solution is the most general one in that it also comprises the previous one if packets with unitary length are involved.

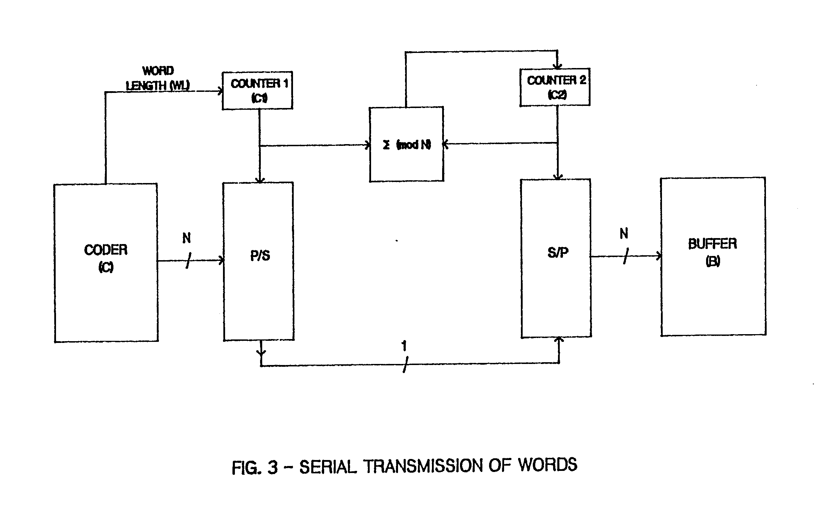

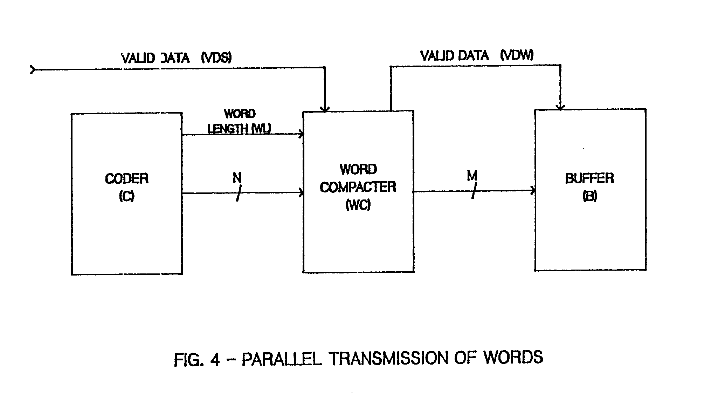

The two alternative solutions are shown in figures 3 and 4.

The first solution is suitable for low speed source S. In fact, parallel to serial conversion originates a peak speed increase (critical parameter of the system) from Fs to $N \cdot Fs$ where N equals the maximum length of the utilized code.

So if initially Fs is not low enough it is easy to reach very high peak frequencies.

For instance: $Fs = 27MHz$ (video signal with components YUV 4:2:2), $N = 8:N8Fs = 216MHz \rightarrow$ clock cycle < 5 ns.

In this case a parallel mode is preferred. By utilizing packets with length M, the peak frequency decreases to $N/M^*Fs$.

Said packets must be prepared by an appropriate WC (Word Compacter) circuitry. For a correct operation this circuitry must know word length WL of the coder words to be made compact.

This information may be supplied directly by coder C in parallel with words W.

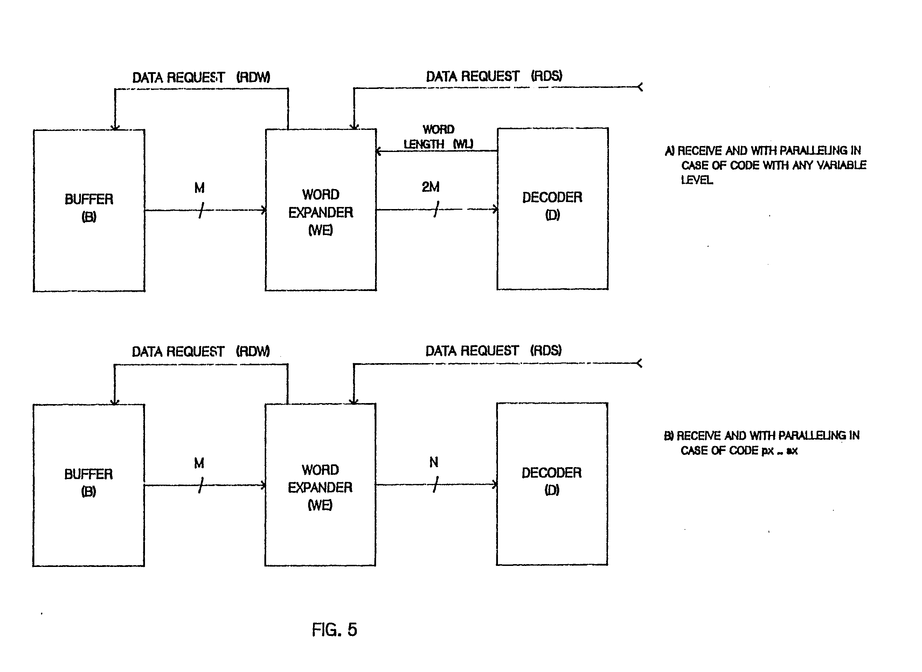

At the receive end, starting from the messages with constant length M the Word Extraction (WE) circuitry supplies words W with variable length and generally does not know length WL of the words to be extracted before the decoder has decoded (recognized) them and consequently send back word length WL (figure 5a).

This ring may imply too much time thus making the solution impracticable.

Moreover, due to compacting a word W may start on one path and end on another, so it is necessary to supply decoder D with several parallel packets thus having to utilize big decoding tables.

A practical solution consists in making the code intrinsically contain information with word length WL thus permitting at the receive end to logically and physically separate the two EXTRACTION and DECODING operations (figure 5b) and connect them in cascade.

The code of this invention (prefix/suffix or briefly [px..] sx) complies with this requirement.

In fact, its structure is so that any word W belonging to it, except the words with maximum length N, is made up of a number n ($O \leq n \leq N$) of prefixes (px) followed by only one suffix (sx).

So in order to determine word length WL of the code to be extracted it is sufficient to determine the position of the suffix that follows.

The words with maximum length N can end without a suffix under the assumption that if no suffix is detected for N bits, word W has length N.

This expansion permits to increase the number of messages (Me) that can be transmitted with the same maximum code length N.

A considerably simplification of the hardware necessary to implement the WC/WE circuitry is obtained by using a step code [px..] sx, such that word length WL of one word W is a multiple of a certain step St:

$$1 = n^* ST (1 < = n < = N/ST) \qquad (1)$$

and utilizing a packet with length M such as:

$$M = m^* ST (1 < = m < = M/St) \qquad (2)$$

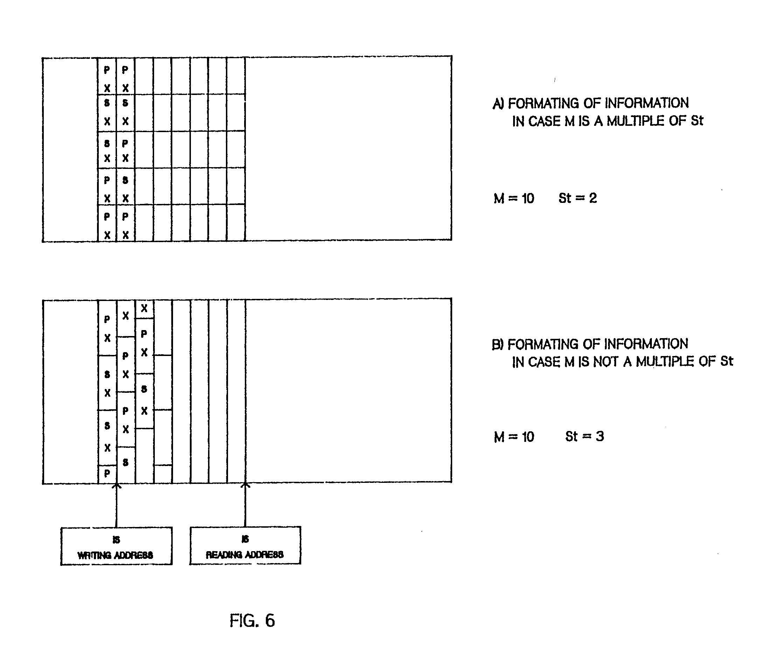

i e step St must be a submultiple of length M of the packet. For instance, if M = 16 the following choices are possible: St = 1,2,4,8 thus giving rise to four possible step codes [px..] sx. Conditions (1) and (2) cause the bit (phase) positions of [px..] sx to be always the same inside a packet (figure 6a).

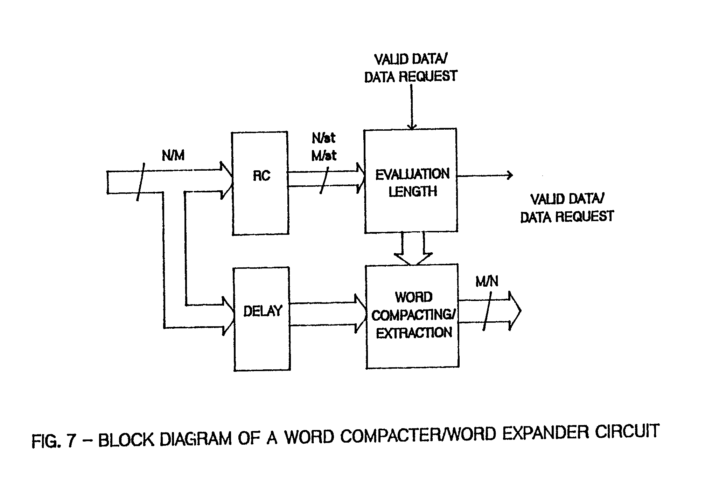

In this way, both compacting and extraction are possible by examining N/St bits generally obtained by means of a simple input bit combining network (figure 7).

Another example may be useful.

Under the assumption to choose a code [px..] sx with step St = 2, the code words are all formed by combining the following four latches S1 = 00, S2 = 01, S3 = 10, S4 = 11.

A few of them may be chosen as px, the other ones as sx, e g sx = [S1, S2] and px = [S3, S4].

It is immediately evident that the distinction between px and sx is determined by the value of the first bit. If we think of how words W consisting of these four latches are made compact, we realize that inside the received packet only 50% of the bits (even or odd according to the conventions) contain the information with length WL. For the sake of shortness, this subassembly is referred to as "PS bits", whereas the other ones are called "XY bits" (figure 6b).

So, if M = 16, word expander WE will only separate the 8 PS bits from the reamining bits (XY) and correctly extract successive word W as a function of their configuration. This logic separation of PS bits from XY bits can also be expolited at the transmit end or when generating PS bits starting from length WL of word W received by coder C or vice versa obtaining length WL of word W to be made compact by PS bits. Anyway XY bits inside the word compacter/ word extracter circuitry are slaves with respect to PS bits, i e their evolution is followed.

Under the assumption that infinite step codes [px..] sx are possible and in view of the fact that here further attention cannot be dedicated to the theory of their characteristics, an analysis is given of the implementation of the two devices word compacter, word extractor of the case where N = M = 16, St = 2, to which belong also words W with length N and without suffix.

## WORD COMPACTER

As already stated, the two choices are possible for formating the word compacter incoming information:

1. Input with code word [px..] sx and successive extraction of its length WL inside the word compacter through a combining network (figure 7).

2. Input with only XY bits of the code word [px..] sx and parallel to its length WL sufficient information to obtain PS bits to be sent to the output.

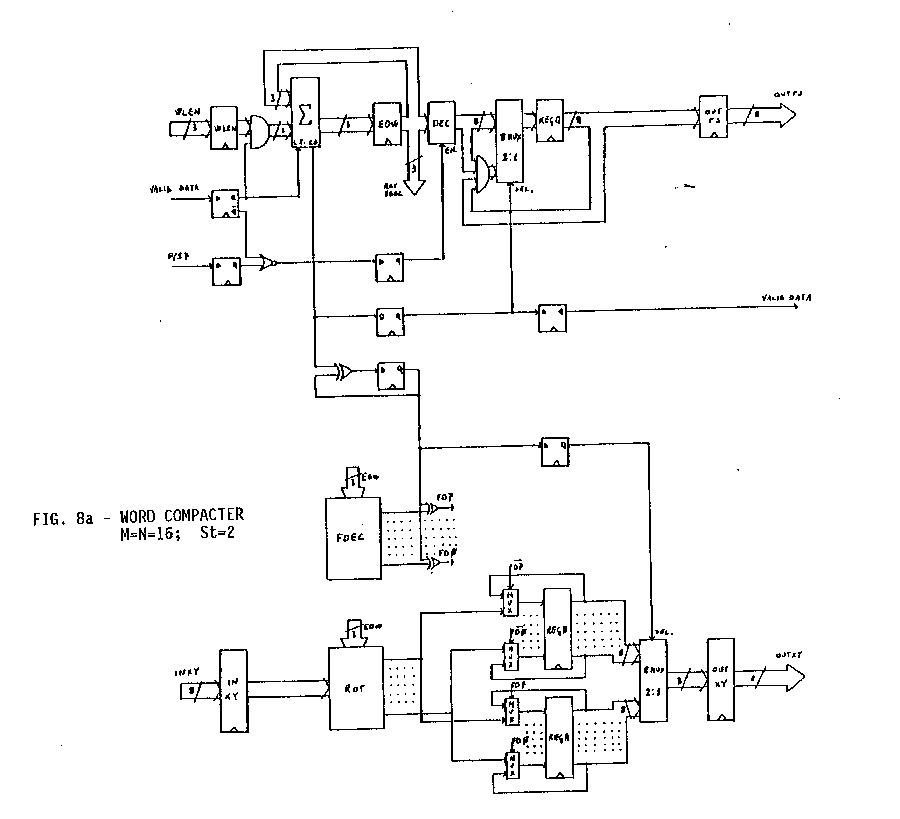

The electrical digaram of the case where N = M = 16, St = 2 shown in figure 8a adopts the second solution in that it permits the minimize the bits at the output of coder C (12 instead of 16).

The input (and relevant recording) bits have the following meaning:
- 8 XY bits (INXY)
- 3 bits with length WL (WLEN)
- 1 auxiliary bit (P/S7)
in addition to the VALID DATA bit, which is supplied directly by source S bypassing coder C.

The purpose of auxiliary bit P/S7 is to specify in case of maximum word length N = 16, whether the last latch of word W is a prefix px or a suffix sx.

Lengths WL are mapped according to the following law:

$$
\left.
\begin{array}{ll}
N \;=\; 2 & \text{WLEN} \;=\; 0 \\[4pt]
N \;=\; 4 & \text{WLEN} \;=\; 1 \\[4pt]
\text{''} & \text{''} \\[4pt]
N \;=\; 16 & \text{WLEN} \;=\; 7
\end{array}
\right\} \quad \text{WLEN} = N/2 - 1
$$

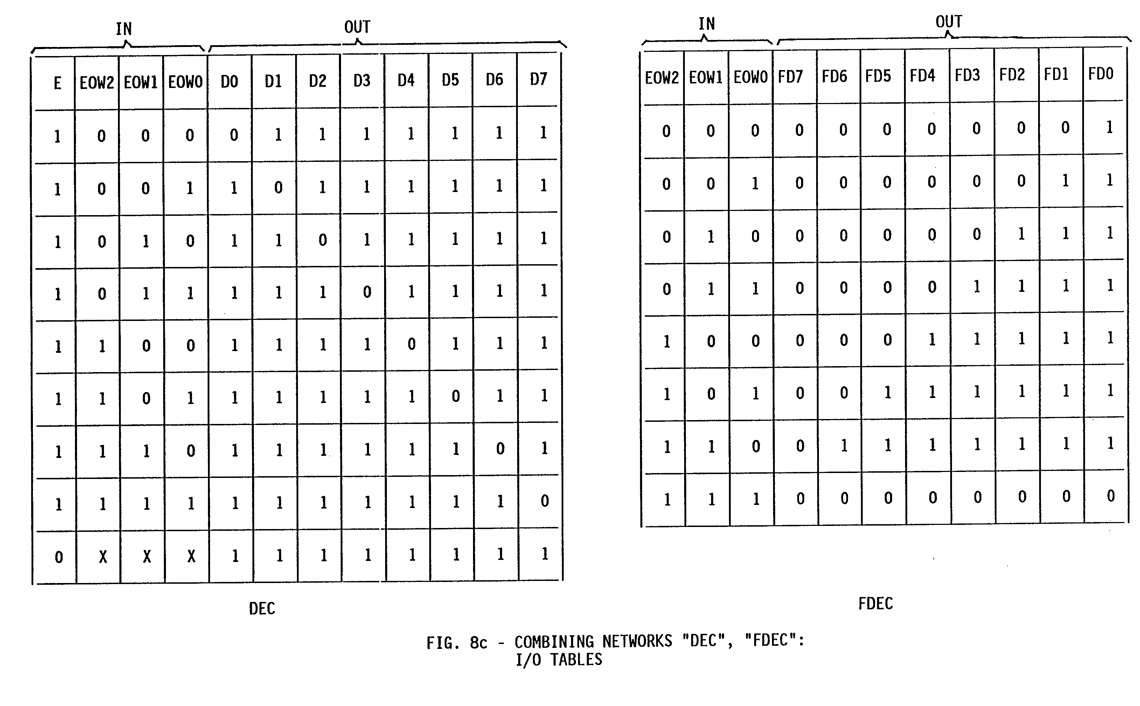

The upper part of the circuitry is the socalled "PS side" which besides updating the EOW counter also determines PS bits to be sent to the output through a combining network "DEC" (figure 8c). The valid data output is determined directly by the carry out of the adder modulus 8 which updates the EOW counter. Whenever carry out = 1, it means that a packet has been stuffed and is ready to be sent to buffer B downstreams.

The lower part of the circuitry is the "XY side" and receives four bits (three of which are EOW) from the above mentioned PS side.

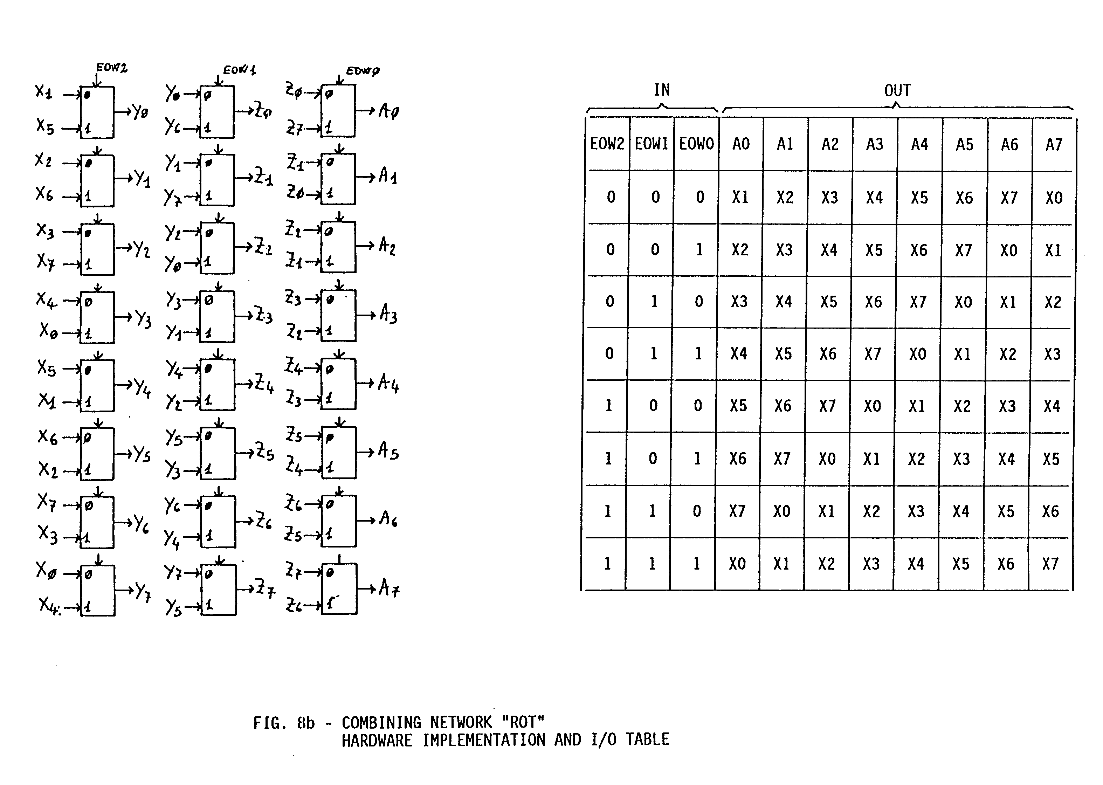

Through rotary combining "ROT", decoding "FDEC (figures 8b, 8c) and select MUX networks this information controls the development of the 8 input XY bits vs the 8 output bits (OUTXY).

## WORD EXTRACTOR

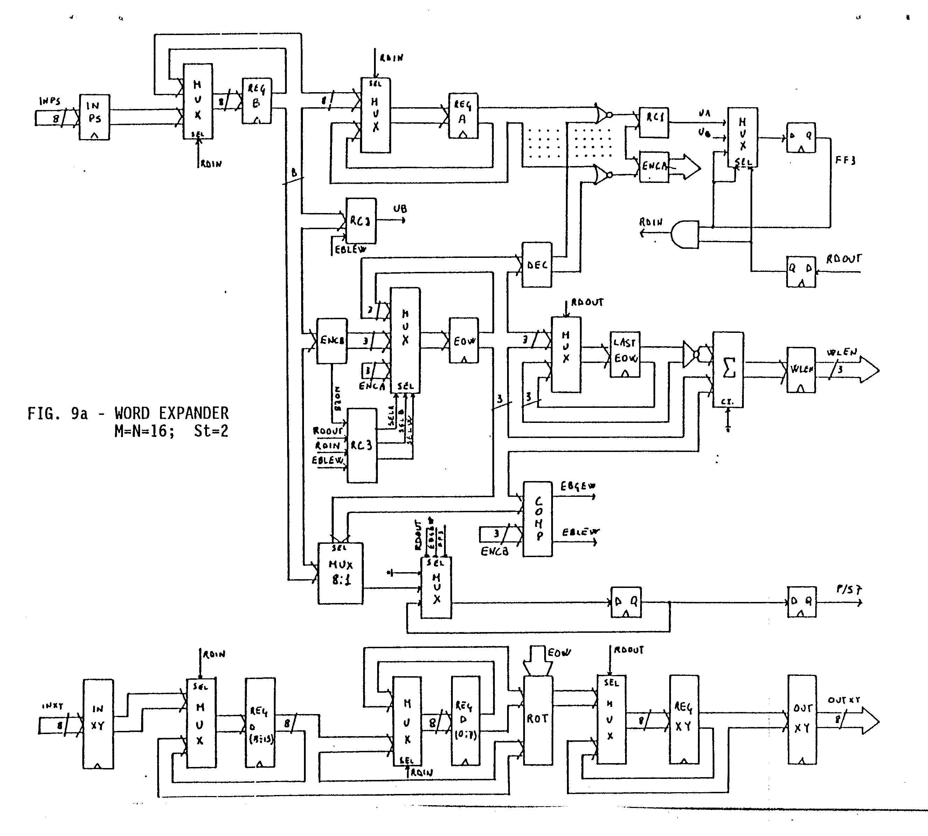

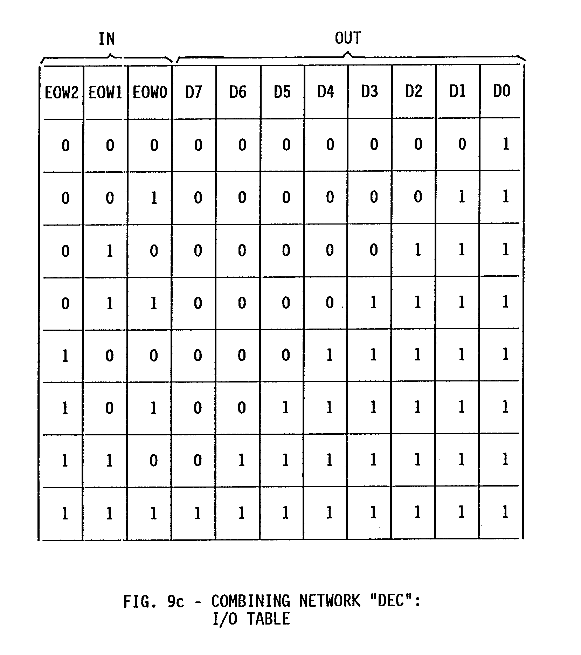

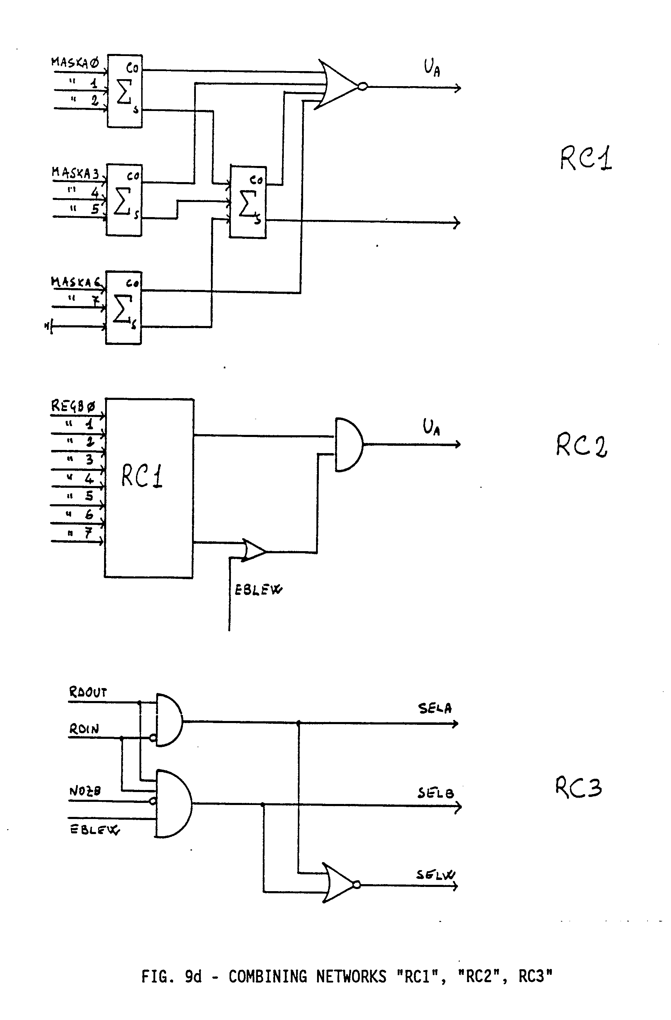

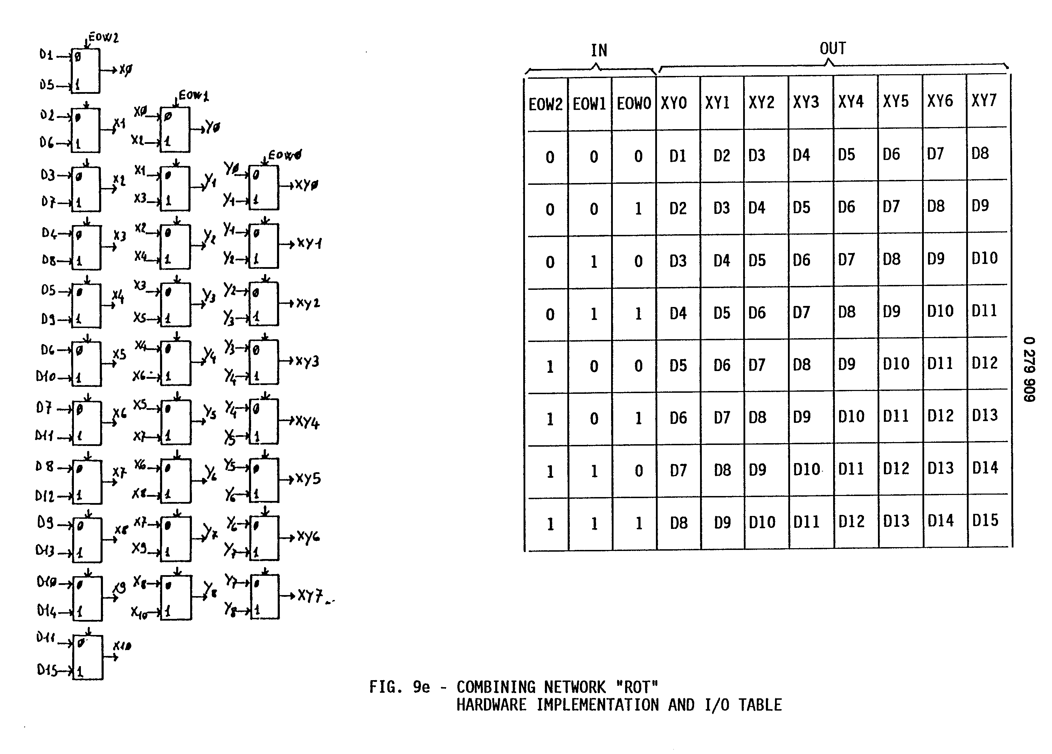

The electrical diagram of word extractor WE in the case where N = M = 16, St = 2 is shown in figure 9a.

Unlike the transmit end, the receive end is not provided with the two alternative solutions described for the word compacter, so starting from the packet received at the input, the information with length WL must be obtained inside word extractor WE (figure 7).

The combining network extracting the information with length WL in this case is limited to a simple separation of PS bits from incoming interconnected XY bits.

A distinction always exists between a PS side and an XY side: the PS side is much more complex with respect to the word compacter in that each packet can contain several packaged words W.

Besides a word W can also start on one packet and end on the one that follows. Therefore two EOW counters (EOW, LASTEOW) are necessary and at the same time two recorders A, B must be examined.

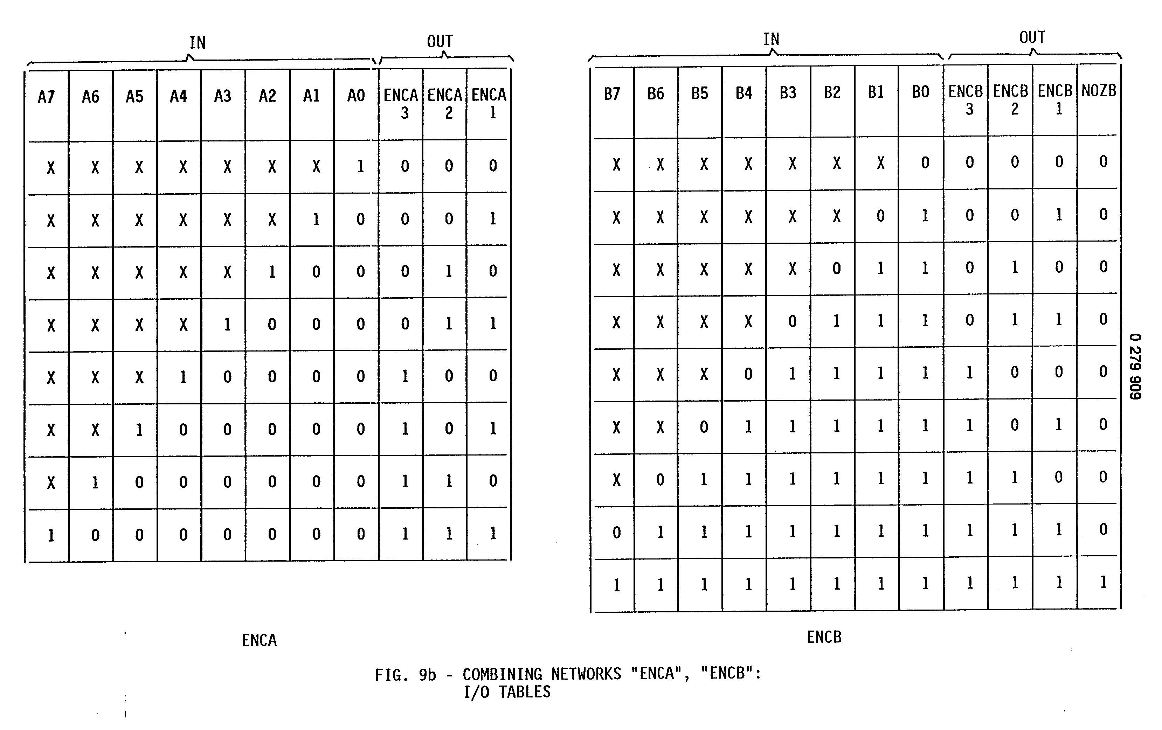

In fact, they contain PS bits of two successive packets and gradually supply lengths WL of the contained words W through combining networks "ENCA" "ENCB" (figure 9b).

The whole circuit is developed only if signal RDOUT is present, i e the data request from source S.

Signal RDIN, i e the data request from word extractor WE to buffer B is generated by means of combining networks RC1, RC2 and as a function of signal RDOUT.

The output information format coincides with the information format at the input of word compacter WC.

**Claims**

1) System for paralleling words W with length WL and variable frequency, characterized by the fact that it operates with a step code [px..] sx, i.e each word W (except the word with maximum length N) is formed by a sequence of a number varying from O to N/St of prefixes followed by only one suffix sx.

2) System according to claim 1, characterized by the fact that the length of each prefix px and suffix sx of said code equals a value St (step) from time to time constant, so that length WL of each word W belonging to said code is a multiple of step St according to the following equation:

$1 = n * St (1 < = n < = N/St)$

3) System according to claim 2, characterized by the fact that words W of said code are transmitted in packets with length M from time to time multiple constant of said step St as per the following equation:

$M = m * St (1 < = m < = M/St)$

4) System according to description and representation.

5) Device to implement the system according to the above claims, characterized by the fact that at the transmit end a word compacter WC is inserted between coder C and buffer B, which word compacter receives words W with variable length WL from coder C and transmits to buffer B packets of bits with constant length M by operating at peak frequency equalling N/M*Fs.

6) Device to implement the system according to claims 1-3, characterized by the fact that at the receive end a word extractor WE is inserted between buffer B and decoder D, which extractor receives packets of bits with constant length M from buffer B and transmits to decoder D words W with variable length WL operating at peak frequency equalling N/M*Fs.

7) Device according to claim 5, characterized by a word compacter as shown in figures 8a, 8b, 8c for the case where N = M = 16, St = 2.

8) Device according to claim 6), characterized by a word compacter as shown in figures 9a, 9b, 9c, 9d, 9e for the case where N = M = 16, St = 2.

9) Devices and circuitry according to description and representation.

FIG. 1 -- BLOCK DIAGRAM OF A TRANSMISSION SYSTEM

0 279 909

A) BUFFER B CONTAINING NON
COMPACT INFORMATION IN Z.
THE STUFFING LEVEL RESULTS
TO BE > THE RIAL LEVEL.

IL
READING ADDRESS

IS
WRITING ADDRESS

B) ELASTIC MEMORY CONTAINING
COMPACT INFORMATION IN $Z_c < Z$.
THE STUFFING LEVEL RESULTS
TO BE EQUAL TO THE RIAL LEVEL.

IL'
READING ADDRESS

IS'
WRITING ADDRESS

FIG. 2

FIG. 3 – SERIAL TRANSMISSION OF WORDS

0 279 909

FIG. 4 - PARALLEL TRANSMISSION OF WORDS

DATA REQUEST (RDW)       DATA REQUEST (RDS)

WORD LENGTH (WL)

BUFFER (B) — M → WORD EXPANDER (WE) — 2M → DECODER (D)

A) RECEIVE AND WITH PARALLELING IN CASE OF CODE WITH ANY VARIABLE LEVEL

DATA REQUEST (RDW)       DATA REQUEST (RDS)

BUFFER (B) — M → WORD EXPANDER (WE) — N → DECODER (D)

B) RECEIVE AND WITH PARALLELING IN CASE OF CODE px .. ax

FIG. 5

0 279 909

A) FORMATING OF INFORMATION
   IN CASE M IS A MULTIPLE OF St

M = 10     St = 2

B) FORMATING OF INFORMATION
   IN CASE M IS NOT A MULTIPLE OF St

M = 10     St = 3

IS
WRITING ADDRESS

IS
READING ADDRESS

FIG. 6

0 279 909

FIG. 7 – BLOCK DIAGRAM OF A WORD COMPACTER/WORD EXPANDER CIRCUIT

FIG. 8a - WORD COMPACTER
M=N=16;  St=2

0 279 909

| EOW2 | EOW1 | EOWO | A0 | A1 | A2 | A3 | A4 | A5 | A6 | A7 |
|------|------|------|----|----|----|----|----|----|----|----|
| 0 | 0 | 0 | X1 | X2 | X3 | X4 | X5 | X6 | X7 | X0 |
| 0 | 0 | 1 | X2 | X3 | X4 | X5 | X6 | X7 | X0 | X1 |
| 0 | 1 | 0 | X3 | X4 | X5 | X6 | X7 | X0 | X1 | X2 |
| 0 | 1 | 1 | X4 | X5 | X6 | X7 | X0 | X1 | X2 | X3 |
| 1 | 0 | 0 | X5 | X6 | X7 | X0 | X1 | X2 | X3 | X4 |
| 1 | 0 | 1 | X6 | X7 | X0 | X1 | X2 | X3 | X4 | X5 |
| 1 | 1 | 0 | X7 | X0 | X1 | X2 | X3 | X4 | X5 | X6 |
| 1 | 1 | 1 | X0 | X1 | X2 | X3 | X4 | X5 | X6 | X7 |

FIG. 8b - COMBINING NETWORK "ROT"
HARDWARE IMPLEMENTATION AND I/O TABLE

## DEC

| | IN | | | | | | OUT | | | | |
|---|---|---|---|---|---|---|---|---|---|---|---|
| E | EOW2 | EOW1 | EOW0 | D0 | D1 | D2 | D3 | D4 | D5 | D6 | D7 |
| 1 | 0 | 0 | 0 | 0 | 1 | 1 | 1 | 1 | 1 | 1 | 1 |
| 1 | 0 | 0 | 1 | 1 | 0 | 1 | 1 | 1 | 1 | 1 | 1 |
| 1 | 0 | 1 | 0 | 1 | 1 | 0 | 1 | 1 | 1 | 1 | 1 |
| 1 | 0 | 1 | 1 | 1 | 1 | 1 | 0 | 1 | 1 | 1 | 1 |
| 1 | 1 | 0 | 0 | 1 | 1 | 1 | 1 | 0 | 1 | 1 | 1 |
| 1 | 1 | 0 | 1 | 1 | 1 | 1 | 1 | 1 | 0 | 1 | 1 |
| 1 | 1 | 1 | 0 | 1 | 1 | 1 | 1 | 1 | 1 | 0 | 1 |
| 1 | 1 | 1 | 1 | 1 | 1 | 1 | 1 | 1 | 1 | 1 | 0 |
| 0 | X | X | X | 1 | 1 | 1 | 1 | 1 | 1 | 1 | 1 |

## FDEC

| IN | | | OUT | | | | | | | |
|---|---|---|---|---|---|---|---|---|---|---|
| EOW2 | EOW1 | EOW0 | FD7 | FD6 | FD5 | FD4 | FD3 | FD2 | FD1 | FD0 |
| 0 | 0 | 0 | 0 | 0 | 0 | 0 | 0 | 0 | 0 | 1 |
| 0 | 0 | 1 | 0 | 0 | 0 | 0 | 0 | 0 | 1 | 1 |
| 0 | 1 | 0 | 0 | 0 | 0 | 0 | 0 | 1 | 1 | 1 |
| 0 | 1 | 1 | 0 | 0 | 0 | 0 | 1 | 1 | 1 | 1 |
| 1 | 0 | 0 | 0 | 0 | 0 | 1 | 1 | 1 | 1 | 1 |
| 1 | 0 | 1 | 0 | 0 | 1 | 1 | 1 | 1 | 1 | 1 |
| 1 | 1 | 0 | 0 | 1 | 1 | 1 | 1 | 1 | 1 | 1 |
| 1 | 1 | 1 | 0 | 0 | 0 | 0 | 0 | 0 | 0 | 0 |

FIG. 8c - COMBINING NETWORKS "DEC", "FDEC":
I/O TABLES

0 279 909

FIG. 9a - WORD EXPANDER
M=N=16;  St=2

0 279 909

| IN | | | | | | | | OUT | | |
|---|---|---|---|---|---|---|---|---|---|---|
| A7 | A6 | A5 | A4 | A3 | A2 | A1 | A0 | ENCA 3 | ENCA 2 | ENCA 1 |
| X | X | X | X | X | X | X | 1 | 0 | 0 | 0 |
| X | X | X | X | X | X | 1 | 0 | 0 | 0 | 1 |
| X | X | X | X | X | 1 | 0 | 0 | 0 | 1 | 0 |
| X | X | X | X | 1 | 0 | 0 | 0 | 0 | 1 | 1 |
| X | X | X | 1 | 0 | 0 | 0 | 0 | 1 | 0 | 0 |
| X | X | 1 | 0 | 0 | 0 | 0 | 0 | 1 | 0 | 1 |
| X | 1 | 0 | 0 | 0 | 0 | 0 | 0 | 1 | 1 | 0 |
| 1 | 0 | 0 | 0 | 0 | 0 | 0 | 0 | 1 | 1 | 1 |

ENCA

| IN | | | | | | | | OUT | | | |
|---|---|---|---|---|---|---|---|---|---|---|---|
| B7 | B6 | B5 | B4 | B3 | B2 | B1 | B0 | ENCB 3 | ENCB 2 | ENCB 1 | NOZB |
| X | X | X | X | X | X | X | 0 | 0 | 0 | 0 | 0 |
| X | X | X | X | X | X | 0 | 1 | 0 | 0 | 1 | 0 |
| X | X | X | X | X | 0 | 1 | 1 | 0 | 1 | 0 | 0 |
| X | X | X | X | 0 | 1 | 1 | 1 | 0 | 1 | 1 | 0 |
| X | X | X | 0 | 1 | 1 | 1 | 1 | 1 | 0 | 0 | 0 |
| X | X | 0 | 1 | 1 | 1 | 1 | 1 | 1 | 0 | 1 | 0 |
| X | 0 | 1 | 1 | 1 | 1 | 1 | 1 | 1 | 1 | 0 | 0 |
| 0 | 1 | 1 | 1 | 1 | 1 | 1 | 1 | 1 | 1 | 1 | 0 |
| 1 | 1 | 1 | 1 | 1 | 1 | 1 | 1 | 1 | 1 | 1 | 1 |

ENCB

FIG. 9b - COMBINING NETWORKS "ENCA", "ENCB":
I/O TABLES

0 279 909

|     | IN   |      |     |     |     | OUT |     |     |     |     |
| --- | ---- | ---- | --- | --- | --- | --- | --- | --- | --- | --- |
| EOW2 | EOW1 | EOW0 | D7  | D6  | D5  | D4  | D3  | D2  | D1  | D0  |
| 0   | 0    | 0    | 0   | 0   | 0   | 0   | 0   | 0   | 0   | 1   |
| 0   | 0    | 1    | 0   | 0   | 0   | 0   | 0   | 0   | 1   | 1   |
| 0   | 1    | 0    | 0   | 0   | 0   | 0   | 0   | 1   | 1   | 1   |
| 0   | 1    | 1    | 0   | 0   | 0   | 0   | 1   | 1   | 1   | 1   |
| 1   | 0    | 0    | 0   | 0   | 0   | 1   | 1   | 1   | 1   | 1   |
| 1   | 0    | 1    | 0   | 0   | 1   | 1   | 1   | 1   | 1   | 1   |
| 1   | 1    | 0    | 0   | 1   | 1   | 1   | 1   | 1   | 1   | 1   |
| 1   | 1    | 1    | 1   | 1   | 1   | 1   | 1   | 1   | 1   | 1   |

FIG. 9c - COMBINING NETWORK "DEC":
I/O TABLE

FIG. 9d - COMBINING NETWORKS "RC1", "RC2", RC3"

| IN | | | OUT | | | | | | | |
|---|---|---|---|---|---|---|---|---|---|---|
| EOW2 | EOW1 | EOW0 | XY0 | XY1 | XY2 | XY3 | XY4 | XY5 | XY6 | XY7 |
| 0 | 0 | 0 | D1 | D2 | D3 | D4 | D5 | D6 | D7 | D8 |
| 0 | 0 | 1 | D2 | D3 | D4 | D5 | D6 | D7 | D8 | D9 |
| 0 | 1 | 0 | D3 | D4 | D5 | D6 | D7 | D8 | D9 | D10 |
| 0 | 1 | 1 | D4 | D5 | D6 | D7 | D8 | D9 | D10 | D11 |
| 1 | 0 | 0 | D5 | D6 | D7 | D8 | D9 | D10 | D11 | D12 |
| 1 | 0 | 1 | D6 | D7 | D8 | D9 | D10 | D11 | D12 | D13 |
| 1 | 1 | 0 | D7 | D8 | D9 | D10 | D11 | D12 | D13 | D14 |
| 1 | 1 | 1 | D8 | D9 | D10 | D11 | D12 | D13 | D14 | D15 |

FIG. 9e - COMBINING NETWORK "ROT"
HARDWARE IMPLEMENTATION AND I/O TABLE

0 279 909